# EUROPEAN PATENT SPECIFICATION

(11) **EP 3 655 991 B1**
(45) Date of publication and mention of the grant of the patent: **28.12.2022**
(21) Application number: 18737579.5
(22) Date of filing: 03.07.2018
(51) Int. Cl.: H01L 27/146

(54) **BACK SIDE ILLUMINATED PHOTODETECTOR FOR CMOS IMAGING SENSOR WITH PHOTOACTIVE LAYER IN A CAVITY**
RÜCKSEITIG BELEUCHTETER PHOTODETEKTOR FÜR CMOS-BILDSENSOR MIT PHOTOAKTIVER SCHICHT IN EINEM HOHLRAUM
PHOTODÉTECTEUR RÉTROÉCLAIRÉ POUR CAPTEUR D'IMAGERIE CMOS AVEC COUCHE PHOTOACTIVE DANS UNE CAVITÉ

(30) Priority: 19.07.2017 FI 20175697
(43) Date of publication of application: 27.05.2020
(73) Proprietor: Emberion Oy, 02130 Espoo (FI)
(72) Inventor: POHJONEN, Helena, 02360 Espoo (FI); KALLIOINEN, Sami, 02610 Espoo (FI)
(74) Representative: Boco IP Oy Ab
(86) International application number: PCT/EP2018/067913
(87) International publication number: WO 2019/015951

(56) References cited:
- US-A1- 2012 049 044
- US-A1- 2015 108 425
- F. H. L. KOPPENS ET AL: "Photodetectors based on graphene, other two-dimensional materials and hybrid systems", NATURE NANOTECHNOLOGY, vol. 9, no. 10, 6 October 2014 (2014-10-06), pages 780-793, XP055308875, GB ISSN: 1748-3387, DOI: 10.1038/nnano.2014.215

## Description

### FIELD OF THE DISCLOSURE

The present disclosure relates to photodetectors which utilize semiconductor field-effect transistors for light detection, and more particularly to photodetectors containing one or more photovoltaic field-effect transistors (PVFET) where the electrical conductivity of the channel is optically modulated with a photoactive material. The disclosure also discloses methods for integrating photovoltaic field-effect transistors into complementary metal-oxide-semiconductor (CMOS) structures by back-side processing and for resetting photovoltaic field-effect transistors.

### BACKGROUND OF THE DISCLOSURE

Semiconductor components utilizing complementary metal-oxide-semiconductor (CMOS) technology have many inherent advantages in imaging applications where light intensity is measured. CMOS enables integration of pn-junction based imaging devices with low power consumption, with CMOS voltage levels for visible wavelengths producing minimum number of parts in the system. Most battery powered imaging systems use CMOS due to the benefits of having fewer parts in the system without needing high driving voltages.

CMOS photodetectors typically utilize either photodiodes or junction field-effect (JFET) transistors for detecting light intensity. Document US6512280 discloses a CMOS structure where a buried photodiode forms the light-sensitive element, while document US5705846 discloses a CMOS structure where a junction field-effect transistor forms the light-sensitive element.

A common problem with both photodiodes and junction field-effect transistors in silicon CMOS structures is that their sensitivity is relatively low, and their optical response is restricted to a fairly narrow spectrum of wavelengths. Integration of additional optical elements which facilitate higher sensitivity and broader spectral sensitivity into CMOS photodetectors has proved to be a difficult task. Such elements should be compatible with standard CMOS power, signal and logic functionalities, which require biasing and grounding. Compatibility with typical CMOS materials, such as aluminium metallization on the top surface, is often an additional requirement.

Document US 2015/0108425 A1 presents a back-illuminated optical device where a recess is formed in a wafer with a buried oxide film. Document US 2012/0049044 A1 discloses a solid-state imaging device configured as a back-illuminated type in which light is incident from a surface opposite to the surface on which the pixel transistors are formed.

### BRIEF DESCRIPTION OF THE DISCLOSURE

An object of the present disclosure is to provide an apparatus which overcomes the above problems. The objects of the disclosure are achieved by an arrangement which is characterized by what is stated in the independent claims. The preferred embodiments of the disclosure are disclosed in the dependent claims.

The disclosure is based on the idea of forming a back-side illuminated photovoltaic field-effect transistor, where sensitivity is increased with a photoactive layer. A transistor channel region in the field-effect transistor transports charge from the source to the drain. The photoactive layer is placed adjacent to the channel, where it can be illuminated by radiation which enters the photodetector from a back-side cavity. Radiation creates an illumination-dependent photovoltage at the interface between the silicon channel and the photoactive layer. With appropriate design, the charge transport in the transistor can be made a very sensitive indicator of illumination intensity. The spectral sensitivity of the transistor may be tuned by selecting photoactive layers which are sensitive to certain wavelengths.

An advantage of the arrangement presented in this disclosure is that a back-side illuminated photovoltaic field-effect transistors can be integrated with standard CMOS circuit arrangements on the front side of the wafer in a simple process which only requires 2-4 masking steps in addition to the ones needed for the CMOS circuit, with no additional processing on the front side of the CMOS circuit after the transistor structures have been prepared and contacted. The proposed back-side illuminated pixels can also achieve higher fill ratios than front-side illuminated pixels.

### BRIEF DESCRIPTION OF THE DRAWINGS

In the following the disclosure will be described in greater detail by means of preferred embodiments with reference to the accompanying drawings, in which
Figure 1 illustrates a photodetector with a field-effect transistor pixel according to one embodiment.
Figure 2 illustrates a photodetector with a field-effect transistor pixel according to another embodiment.
Figures 3a - 3i illustrate a method for manufacturing a photosensitive field-effect transistor in a silicon substrate.
Figure 4a illustrates a bipolar reset-transistor for removing accumulated charge from the channel region of a field-effect transistor pixel.
Figure 4b illustrates the corresponding reset circuit for one field-effect transistor pixel.
Figure 5a illustrates another bipolar reset-transistor for removing accumulated charge from the channel region of a field-effect transistor pixel.
Figure 5b illustrates the corresponding reset circuit for one field-effect transistor pixel.
Figure 6a illustrates the reset circuit for an nMOS reset transistor which removes accumulated charge from a field-effect transistor pixel.
Figure 6b illustrates the reset circuit for a pMOS reset transistor which removes accumulated charge from a field-effect transistor pixel.

### DETAILED DESCRIPTION OF THE DISCLOSURE

This disclosure relates to a photodetector with a front surface and a back surface, comprising a silicon substrate with a corresponding front surface and a corresponding back surface. The silicon substrate comprises one or more field-effect transistor pixels. The field-effect transistor pixels comprise a source region on the front surface of the silicon substrate and a conductive source electrode connected to the source region, a gate region on the front surface of the silicon substrate and a conductive gate electrode connected to the gate region, a drain region on the front surface of the silicon substrate and a conductive drain electrode connected to the drain region. Each field-effect transistor pixel further comprises a transistor channel region encompassing the source, gate and drain regions on the front surface of the silicon substrate. The silicon substrate has been doped to a first conductivity type in the transistor channel region. Each field-effect transistor pixel further comprises a transistor well encompassing the transistor channel region on the front surface of the silicon substrate. The silicon substrate has been doped to a second conductivity type in the transistor well.

Furthermore, each field-effect transistor pixel comprises a cavity extending from the back surface of the silicon substrate to the transistor channel region, wherein the top of the cavity comprises a photoactive layer which is in contact with the transistor channel region. The photoactive layer is configured to generate a photovoltage at the interface between the photoactive layer and the transistor channel region. The cavity also comprises an at least partly transparent encapsulation layer overlying the photoactive layer in the cavity. One or more openings in the back surface of the photodetector are aligned with one more field-effect transistor pixels and allow electromagnetic radiation to reach the cavity in the one or more field-effect transistor pixels.

In this disclosure, the expression "first conductivity type" refers either to n-type doping, where additional free electrons have been introduced into a region of the silicon substrate, for example by implanting or diffusing a donor material, such as phosphorus, into the silicon substrate, or to p-type doping, where the number of free electrons has been reduced, for example by implanting or diffusing an acceptor material, such as boron, into a region of the silicon substrate. The expression "second conductivity type" refers to the other of these two doping types, so that if "first conductivity type" in any given context refers to n-type, then "second conductivity type" refers to p-type in that context, and vice versa. The + sign following the letters p or n is used to denote strongly doped regions, so that a p+ doped region, for example, is a region which has been strongly doped with an acceptor material. A minus sign following the letters p or n may be used to denote weakly doped regions.

The expression "electrical conductivity" will be used to refer to the physical quantity which expresses how well a material or layer conducts electricity. This quantity may also be called conductance. In other words, a change in electrical conductivity in a given layer means a change in its ability to conduct electricity.

In this disclosure, expressions such as "top" and "on top of" refer to sides or elements closer to the front surface of the photodetector, whereas expressions such as "bottom" or "below" refer to sides or elements closer to the back surface of the photodetector. The "vertical" direction is the direction extending from the bottom towards the top, while the "horizontal" direction is the direction extending from left to right in the figures. The expression "corresponding front surface" and "corresponding back surface" is used with reference to the two sides of the silicon substrate. The meaning of this expression is that the surface of the silicon substrate which is closer to the front surface of the photodetector is labelled the front surface of the silicon substrate, and the surface of the silicon substrate which is closer to the back surface of the photodetector is labelled the back surface of the silicon substrate.

In this disclosure, the term "field-effect transistor pixel" refers to a single photovoltaic field-effect transistor which is configured to measure the intensity of light incident upon a given region of the photodetector. A field-effect transistor which constitutes a pixel may also be called a photosensitive field-effect transistor or a photovoltaic field-effect transistor. The photodetector may comprise multiple pixels to facilitate measurement of the spatial distribution of radiation intensity. Different pixels may be sensitized to different ranges of wavelength in the electromagnetic spectrum. The silicon substrate may also comprise transistors which are used for other purposes than photodetection. Such transistors do not constitute field-effect transistor pixels, even though they may be adjacent to pixels.

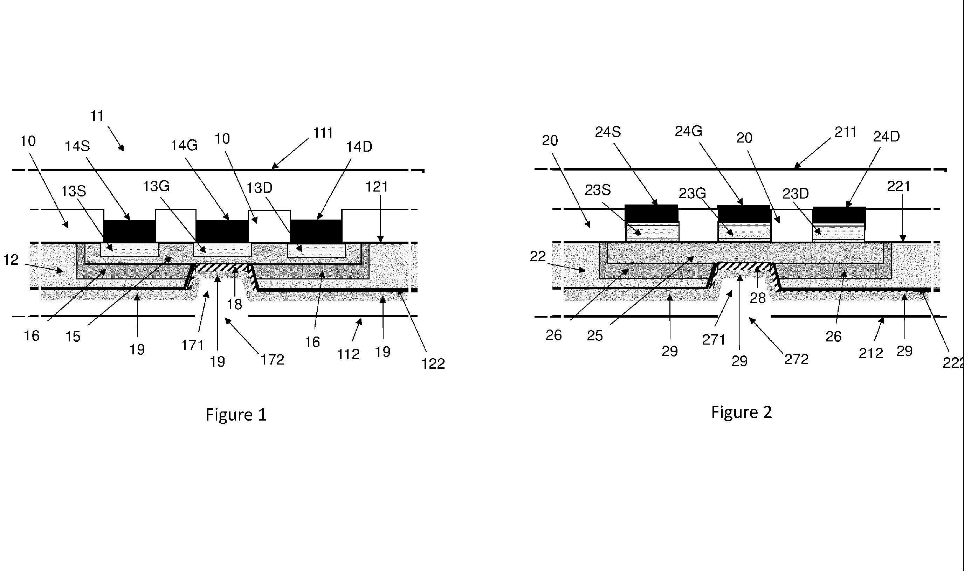

Figure 1 illustrates an embodiment where the photovoltaic field-effect transistor is based on a junction field-effect transistor structure. The figure illustrates a field-effect transistor pixel in a photodetector 11 with a front surface 111 and a back surface 112. The photodetector comprises a silicon substrate 12 with a corresponding front surface 121 and back surface 122. In addition to the silicon substrate, the photodetector may comprise other components between its front surface and back surface 112. The photodetector may comprise a casing which defines the front surface 111 and the back surface 112 of the photodetector. The back surface 112 of the casing may comprise one or more openings 172 where electromagnetic radiation can enter the photodetector and reach a field-effect transistor pixel in the silicon substrate. The photodetector may comprise at least partly transparent encapsulation materials adjacent to the one or more openings. The photodetector may comprise multiple pixels, and it may comprise CMOS circuitry on the same silicon substrate as the field-effect transistor pixels. Many pixels may be formed on the same substrate, so both the substrate and the photodetector may extend sideways beyond the region illustrated in Figure 1.

In the illustrated pixel, the field-effect transistor is initially a junction field-effect transistor where the source region 13S is a region doped to a first conductivity type in the silicon substrate, the gate region 13G is a region doped to a second conductivity type in the silicon substrate, and the drain region 13D is a region doped to the first conductivity type in the silicon substrate. Conductive source (14S), gate (14G) and drain (14G) electrodes have been prepared on top of the source, gate, and drain regions, respectively. These electrodes may be connected to photodetector device circuitry which is not illustrated in Figure 1. An insulating layer 10, for example a silicon dioxide layer, may also be deposited on the front surface of the silicon substrate to separate the electrically active areas from each other.

In the illustrated pixel, the field-effect transistor further comprises a transistor channel region 15 which encompasses the source, gate and drain regions on the front surface of the silicon substrate. When a source voltage is applied between the source (14S) and drain (14G) electrodes, a current may be driven from the source electrode 14S, through the channel region 15 to the drain electrode 14D. The magnitude of this current may be controlled with a gate voltage applied between the source (14S) and gate (14G) electrodes.

In this disclosure, the term "encompass on the front surface of the silicon substrate" means that encompassing region surrounds the encompassed regions on all sides of the encompassed regions which face toward the inside of the silicon substrate. In Figure 1, this means that the transistor channel region 15 surrounds the source, gate and drain regions on all sides except on their top side, which faces away from the inside of the silicon substrate. The field-effect transistor further comprises a transistor well 16 which encompasses the transistor channel region in the same sense.

The junction field-effect transistor in Figure 1 has been converted into a photovoltaic field-effect transistor by depositing additional layers in a cavity 171 in the silicon substrate 12, where electromagnetic radiation can enter the pixel. As illustrated in Figure 1, the cavity 171 extends from the back surface 122 of the silicon substrate 12 to the transistor channel region 15. An opening 172 in the back surface of the photodetector casing allows electromagnetic radiation from the outside to reach the cavity.

As illustrated in Figure 1, the cavity 171 may be partly or entirely filled with a photoactive layer 18 and an at least partly transparent encapsulation layer 19 overlying the photoactive layer 18, which protects the photoactive layer. In this context, the term "overlying" refers to the fact that the encapsulation layer is deposited into the cavity after the photoactive layer has been deposited, as will be described in more detail below. In addition to encapsulation layer 19, the photodetector may also include further encapsulation between the silicon substrate and the photodetector casing.

The photoactive layer 18 may comprise semiconductor nanocrystals or colloidal quantum dots including, but not limited to, PbS, PbSe, PbTe, CdS, CdSe, CdTe, ZnS, ZnO, CuS, Cu₂S, Cu₂Se, CZTS, MnS, Bi₂S₃, Ag2S, Ag2Se, HgTe, CdHgTe, GaSe, MoS₂, CIS, InAs, InSb, Ge, graphene, or core / shell nanocrystals with any of the preceding core / shell constituents. The photoactive layer 18 may alternatively comprise a thin-film layer of any of the preceding materials or combinations thereof. The photoactive layer 18 may alternatively comprise semiconductor nanocrystals or colloidal quantum dots embedded in a host material comprising metal chalcogenide, metal halide, or hybrid halide perovskite of the general formula ABX₃, where A is Cs, CH₃NH₃ or NH2CH=NH2, B is Pb or Sn, and X is CI, Br or I. To enable sufficient charge transport in the photoactive layer 18, the surface of semiconductor nanocrystals or colloidal quantum dots can be passivated by organic, inorganic or hybrid ligands.

When electromagnetic radiation reaches the photoactive layer 18, a photovoltage is created at the interface between the photoactive layer 18 and the channel 15. This photovoltage alters the electrical conductivity of the silicon channel 15 in proportion to the intensity of the incident radiation, so that the field effect transistor becomes a sensitive radiation detector. In other words, the current driven through the channel 15 at a given gate voltage becomes dependent on radiation intensity. This can be described as light modulation of channel charge, a physical effect which can be strongly amplified and easily measured in a field effect transistor geometry.

The field-effect transistor pixel can be sensitized to different wavelengths in the electromagnetic radiation spectrum by selecting the material of the photoactive layer 18 suitably. The electromagnetic radiation may comprise ultraviolet light, visible wavelengths or infrared light.

In the photovoltaic field-effect transistor illustrated in Figure 1, the source and drain regions 13S and 13D may comprise p+ doped regions of silicon beneath the front surface of the silicon substrate. The gate region 13G may then comprise an n+ doped region beneath the front surface of the silicon substrate. The electrical contacts 14S, 14G and 14D may comprise a metallic electrode which is deposited on the corresponding region of the front surface 121 of the silicon substrate, but separated from the silicon substrate by a barrier layer (not illustrated in Figure 1) which prevents the electrode from making direct contact with the silicon substrate. The channel 15 may in this case be p-doped and the transistor well 16 may be n-doped. The conductivities can be reversed, so that the source and drain regions 13S and 13D comprise n+ doped regions, and the gate region 13G comprises a p+ doped region. The channel may in this case be n-doped and the transistor well may be p-doped.

In more general terms, in a photosensitive field-effect transistor pixel, the source region may comprise a region beneath the front surface of the silicon substrate where the silicon substrate has been doped to a first conductivity type, the gate region may comprise a region beneath the front surface of the silicon substrate where the silicon substrate has been doped to a second conductivity type, and the drain region may comprise a region beneath the front surface of the silicon substrate where the silicon substrate has been doped to the first conductivity type. The silicon substrate may be doped to the first conductivity type in the transistor channel region encompassing the source, gate and drain regions, and the silicon substrate may be doped to the second conductivity type in the transistor well which encompasses the transistor channel region.

Figure 2 illustrates an alternative embodiment where the photovoltaic field-effect transistor is based on source, gate and drain regions on the front surface of the silicon substrate. The device components marked with reference numbers 20, 211, 212, 22, 221, 222, 25, 26, 271, 272 28 and 29 in Figure 2 correspond to the components marked with reference numbers 10, 111, 112, 12, 121, 122, 15, 16, 171, 172, 18 and 19 in Figure 1. In contrast to Figure 1, the field-effect transistor pixel illustrated in Figure 2 comprises source (23S), gate (23G) and drain (23D) regions which comprise an insulating layer (silicon dioxide, for example) deposited on top of the front surface of the silicon substrate, and a layer of polycrystalline silicon, which may also be called polysilicon, deposited on the insulating layer. These source (23S), gate (23G) and drain (23D) regions may optionally comprise a silicide layer on top of the layer of polycrystalline silicon. The insulating layer, the polysilicon layer and the optional silicide layer within the source (23S), gate (23G) and drain (23D) regions have been illustrated in Figure 2 with vertical lines within each region. The source (23S), gate (23G) and drain (23D) regions may alternatively comprise a metal layer instead of the polycrystalline silicon layer.

As in the previous embodiment, electrical contact can be made to these source (23S), gate (23G) and drain (23D) regions with metallic source (24S), gate (24G) and drain (24D) electrodes deposited on each region. In the photodetector illustrated in Figure 2, the silicon substrate may be doped to a first conductivity type in the transistor channel region 25 encompassing the source (23S), gate (23G) and drain (23D) regions, and to a second conductivity type in the transistor well 26 which encompasses the transistor channel region 25. In Figure 2, the transistor channel region 25 "encompasses" the source (23S), gate (23G) and drain (23D) regions in the sense that it constitutes the surface beneath their bottom side, which is the side facing toward the inside of the silicon substrate. The transistor well 26 encompasses the transistor channel region 25 in the same sense as in Figure 1. The operating principle of the field-effect transistor pixel illustrated in Figure 2 is the same as the principle described above for the field-effect transistor pixel illustrated in Figure 1.

The two configurations presented for the source, gate and drain regions in Figures 1 and 2 may be combined, so that some of the source, gate and drain regions are manufactured as junction field-effect transistor regions as illustrated in Figure 1, while the remaining source, gate and drain regions are manufactured as nMOS or pMOS regions in the way illustrated in Figure 2. The doping of every source, gate and drain region within the silicon substrate should be selected according to the scheme presented in the discussion relating to Figure 1.

The silicon substrate which is used in the photodetector may be a CMOS substrate comprising adjacent nMOS and pMOS transistor pairs. The silicon substrate may exhibit n-well CMOS structures, where an n-type channel encompasses the source, gate and drain regions of the pMOS transistor while the corresponding regions of the nMOS transistor are surrounded by the bulk silicon of the starting wafer. The silicon substrate may exhibit p-well CMOS structures, where a p-type channel encompasses the source, gate and drain regions of the nMOS transistor, while the corresponding regions of the pMOS transistor are surrounded by the bulk silicon of the starting wafer. A third alternative is that the silicon substrate may exhibit twin-tub CMOS design (also called double well or dual well), where an n-type well encompasses the source, gate and drain regions of the pMOS transistor and a p-type well encompasses the source, gate and drain regions of the nMOS transistor. An additional transistor well may be formed below either the n-type well or the p-type well. Alternatively, the n-type well may be deeper than the p-type well and encompass the p-type well, or vice versa.

From a manufacturing perspective, the method used for preparing any of the CMOS structures outlined above can with small changes be adapted for preparing the front-surface parts of the photovoltaic field-effect transistors described in this disclosure. However, CMOS signalling and grounding, which may be implemented with a p-well connected to ground potential and an n-well connected to a power supply, necessitates careful isolation of the photovoltaic field-effect transistors adjacent to CMOS circuitry.

To separate the channel of the photovoltaic field-effect transistor from the bulk substrate, each photosensitive field-effect transistor must comprise a transistor well which is deeper than the transistor channel region and which encompasses the transistor channel region on the front surface of the silicon substrate. This transistor well can be formed as a separate region which only extends underneath the photovoltaic field-effect transistor, as illustrated in Figures 1 and 2. Alternatively, if the CMOS design is of the n-well type, an n-well which lies adjacent to the photovoltaic field-effect transistor may be extended underneath the photosensitive transistor pixel, so that it encompasses the channel of the photovoltaic transistor and functions as the transistor well of this photovoltaic transistor. If the CMOS design is of the p-well type, the same function can be performed by a p-well adjacent to the pixel. If the CMOS design of the double well type, either the p-well or the n-well may function as the transistor well of the photovoltaic field-effect transistor. The transistor well of the photovoltaic field-effect transistor may be connected to any potential higher than ground potential.

The photodetector may comprise field-effect transistor pixels that are sensitive to different wavelengths, or different wavelength ranges, of electromagnetic radiation. This difference in sensitivity may be produced by depositing a different photoactive layer in these pixels. A first photoactive layer located in the cavity of a first field-effect transistor pixel may create a photovoltage at the interface with the corresponding channel region when illuminated by electromagnetic radiation of a first wavelength or first wavelength range, while a second photoactive layer located in the cavity a second field-effect transistor pixel may create a photovoltage at the interface with the corresponding channel region when illuminated by electromagnetic radiation of a second wavelength or second wavelength range.

The photodetector may comprise a set of first field-effect transistor pixels, and a set of second field-effect transistor pixels, where each set comprises one or more pixels. The number of different pixel sets may be greater than two, and each set of pixels may be equipped with a different photoactive material. When two sets of field-effect transistor pixels are sensitive to different wavelength ranges, these wavelength ranges may in some cases overlap, but spectral sensitivity curves will be different in the two pixel sets.

More generally, the photodetector may comprise N sets of field-effect transistor pixels, wherein each set of field-effect transistor pixels comprises a photoactive layer which differs from the photoactive layers used in the other sets of field-effect transistor pixels. The photoactive layer used in each set of field-effect transistor pixels may be sensitive to a range of electromagnetic radiation wavelengths which differs from the range of wavelengths that the photoactive layers in the other sets of field-effect transistor pixels are sensitive to.

This disclosure also relates to a method for manufacturing a photosensitive field-effect transistor in a silicon substrate of a first conductivity type. The method comprises the step of doping a transistor well with a second conductivity type on a first area on the front surface of the silicon substrate, to a first depth from the front surface of the silicon substrate. The method also comprises the step of doping a transistor channel region on a second area which lies within the first area on the front surface of the silicon substrate, to a second depth from the front surface of the silicon substrate, whereby the second depth is less than the first depth so that the transistor channel region is encompassed by the transistor well. The method also comprises the step of preparing source, gate and drain regions within the second area on the front surface of the silicon substrate, so that the source, gate and drain regions are encompassed by the transistor channel region. The method also comprises the steps of forming a cavity extending from the back surface of the silicon substrate to the second depth from the front surface of the silicon substrate, and forming a dielectric layer on the back surface of the silicon substrate, with an opening at the top of the cavity. The method also comprises the step of forming a photoactive layer on an area of the back surface of the silicon substrate which covers at least the top of the cavity, whereby the photoactive layer makes contact with the transistor channel region and is configured to generate a photovoltage at the interface between the photoactive layer and the channel region when illuminated by electromagnetic radiation.

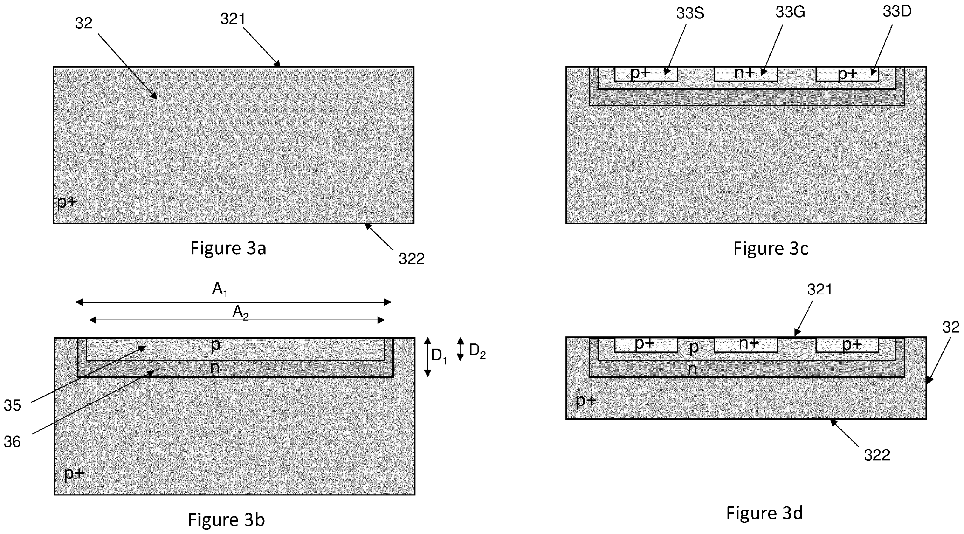

This method is illustrated in Figures 3a - 3i. The photosensitive transistor illustrated in these Figures is based on a junction field-effect transistor formed in a p-type silicon substrate, where source, gate and drain regions are doped regions below the front surface of the silicon substrate.

Figure 3a illustrates a p-type silicon substrate 32 with a front surface 321 and a back surface 322. Some CMOS processes use silicon substrates with bulk p+ doping and a lightly doped p- epitaxial layer on the front surface. The method described in this disclosure is applicable also in such substrates. In Figure 3b, an n-type transistor well 36 has been doped into the silicon substrate 32. The doping may be performed by standard processes such as diffusion or ion implantation. The first area A₁ on the front surface 321, where the transistor well 36 is formed, may be defined by a mask (not illustrated) during the doping process. The transistor well 36 extends down to a first depth D₁ from the front surface 321 after the doping has been completed. As mentioned above, this transistor well may simultaneously function as the n-well or p-well of an adjacent pMOS / nMOS transistor (this alternative, requires that the transistor well extends horizontally to an adjacent pMOS / nMOS transistor). The transistor well 36 may isolate the field-effect transistor pixel from electrically active CMOS circuitry.

Figure 3b also illustrates a p-type transistor channel region 35 which has been doped on a second area A₂ on the front surface 321 of the silicon substrate 32. The second area lies within the first area. The transistor channel region 35 extends down to a second depth D2 from the front surface 321 after the doping has been completed. Since the second depth is less than the first depth, the transistor well 36 encompasses the transistor channel region 35. The transistor well 36 of the photosensitive field-effect transistor may be connected to a higher potential than ground potential. If the surrounding p+ substrate is at ground potential, this creates a reverse-biased diode between the transistor well and the substrate, which isolates the transistor channel region from the substrate.

In Figure 3c, a source region 33S, a gate region 33G and a drain region 33D have been prepared on the front surface 321. These regions are doped to p-type, n-type and p-type, respectively, as illustrated in the figure. The regions 33S, 33G and 33D are prepared within the second area A2 on the front surface and to a lower depth than the second depth D2, so that the transistor channel region encompasses the source, gate and drain regions, as illustrated in Figure 3c. The doping concentrations in the p-, n-, p+ and n+ doped regions illustrated in Figure 3d may be typical CMOS doping levels.

Figure 3d illustrates an optional method step where the silicon substrate 32 is made thinner, for example by chemical mechanical polishing on the back surface 321 of the substrate. If the silicon substrate 32 comprises an epitaxial layer on the front surface, the substrate may be thinned all the way to this epitaxial layer in this step (provided that the epitaxial layer is thicker than the first depth D₁). However, the subsequent process steps may be performed even if the silicon substrate has not been thinned, so this method step may not be needed if the silicon substrate is very thin. Anisotropic etching, which can be stopped at interfaces where doping levels change, may also be used in the substrate thinning process.

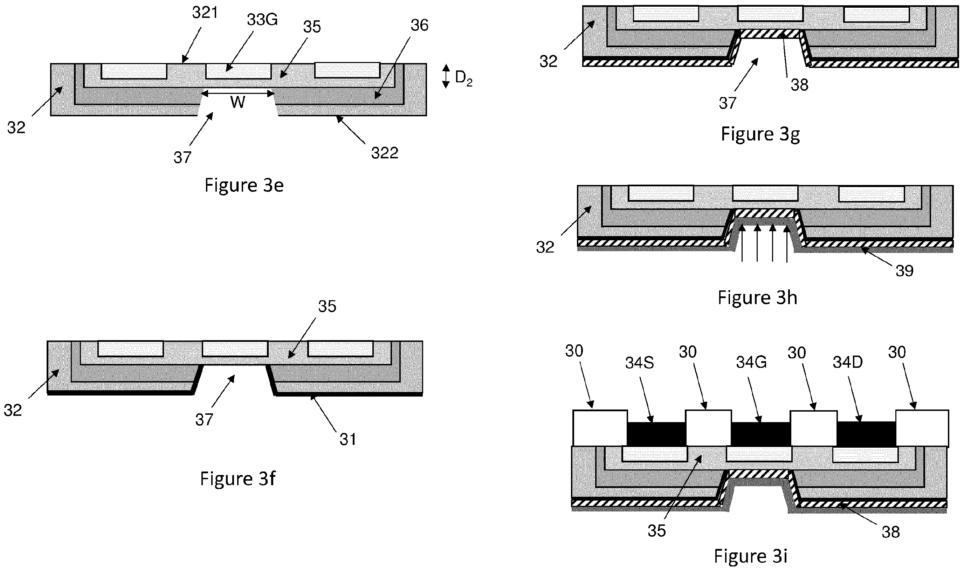

In Figure 3e, a cavity 37 extending from the back surface 322 of the silicon substrate 32 to the second depth D₂ from the front surface 321 of the silicon substrate has been formed. In other words, the cavity 37 extends through the transistor well 36 to the bottom of the transistor channel region 35. The cavity 37 may be etched from the back surface of the silicon substrate with known masking and etching methods. The etchant may, for example, be KOH. The horizontal width W of the cavity 37 may be approximately equal to the horizontal width of the gate region 33G, and the cavity may be aligned with the gate region as illustrated in Figure 3e.

In Figure 3f, a dielectric layer 31 with an opening at the top of the cavity 37 has been formed on the back surface 322 of the silicon substrate 32. The dielectric layer 31 may, for example, be a silicon dioxide layer. The opening may be created in the dielectric layer 31 by etching through the dielectric layer on the top cavity after it has been deposited, or by protecting the top of the cavity with a mask when the dielectric layer is deposited. The purpose of the dielectric layer is to isolate the transistor channel region 35 electrically from the silicon substrate 32, which is critical because surface layers in the substrate may include electrically active regions used for CMOS signalling, as mentioned. Isolation is especially important on the sidewalls of the cavity 37.

In Figure 3g a photoactive layer 38 has been deposited on the back surface of the silicon substrate 32. The photoactive layer 38 may be deposited on a large area of the silicon substrate which extends beyond the sidewalls of the cavity 37, as illustrated in Figure 3g. This large area may even constitute the entire back surface of the silicon substrate. Alternatively, the photoactive layer may be patterned either during or after deposition so that it covers only the top of the cavity 37 and the cavity walls (this alternative is illustrated in Figure 1). In other words, the horizontal width of the photoactive layer 38 may be less than or equal to the horizontal width of the cavity 37.

In the alternative illustrated in Figures 3g - 3i, the horizontal width of the photoactive layer 38 is greater than the horizontal width of the cavity 37. The photoactive layer 38 covers a large area of the back surface of the pixel. The same layer 38 may in this case extend to several field-effect transistor pixels in the photodetector. If the same photoactive layer 38 covers a large area in the photodetector, then each photovoltaic field-effect transistor may require reset means for resetting the transistor for a new measurement, as described in more detail below.

In Figure 3g, the photoactive layer 38 makes contact with the transistor channel region 35 at the top of the cavity 37 and is configured to generate a photovoltage at the interface between the photoactive layer 38 and the transistor channel region 35 when illuminated by electromagnetic radiation.

In Figure 3h an encapsulation layer 39 has been deposited on the back surface of the silicon substrate 32. The encapsulation layer 39 is an overlying layer which covers the photoactive layer at least in the cavity 37. The encapsulation layer may, for example, be a layer of silicon dioxide (SiO₂), Al₂O₃, organic polymers such as poly(p-xylylene) polymers (Parylene C), fluoropolymer materials (Cytop, Teflon), or any suitable transparent dielectric layer. The encapsulation layer should be partly or entirely transparent to the incident radiation, indicated with arrows in Figure 3h. Further layers, such as an antireflective layer, may optionally be formed on the back surface of the silicon substrate.

Electrical contacts 34S, 34G and 34D may be connected to the source, gate and drain regions of the photosensitive field-effect transistor on the front surface of the silicon substrate, in the manner illustrated in Figure 3i. An insulating silicon dioxide layer 30 may also be deposited on the surface to separate the contacts from each other. The contacting scheme may also comprise more complex structures. The contacts can be prepared on the front surface at any suitable time after the transistor components have been completed in the method step illustrated in Figure 3c.

The silicon substrate may finally be encapsulated in a photodetector casing with at least partly transparent openings on the back surface of the casing to allow electromagnetic radiation to reach the photosensitive field-effect transistor.

A similar manufacturing method can be applied when the photovoltaic field-effect transistor is based on source, gate and drain regions comprise insulating and conductive layers deposited on top of the front surface of the silicon substrate, illustrated in Figure 2. Source, gate and drain regions can be prepared on the front side of the silicon substrate with deposition methods. The cavity for back-side illumination with photosensitive layers may be prepared in the manner which was described above.

When the photovoltaic transistor illustrated in Figure 3i detects radiation, the wide layer of photoactive material 38 may cause charge accumulation in the transistor channel 35 during detection. The photosensitive transistor may in some cases be slow to respond to changes in illumination intensity if the accumulation is very extensive. Electrical means for resetting the photovoltaic transistor may therefore be used to remove accumulated charge from a field-effect transistor channel via the field-effect transistor gate, and thereby shorten the response time of the photovoltaic transistor.

If the charge which has accumulated in the channel region of a photosensitive field-effect transistor is positive, then these electrical means may, for example, include one or more bipolar reset transistors formed on the front surface of the same silicon substrate as the one or more field-effect transistor pixels. The bipolar reset transistor may include an emitter region doped to the first conductivity type in the silicon substrate, with a conductive emitter electrode connected to the emitter region and a collector region doped to the second conductivity type in the silicon substrate, with a conductive collector electrode connected to the collector region.

The bipolar reset transistor may further include a first reset transistor well encompassing the emitter and collector regions on the front surface of the silicon substrate, wherein the silicon substrate has been doped to the first conductivity type in the first reset transistor well. The bipolar reset transistor may further include a second reset transistor well encompassing the emitter and collector regions on the front surface of the silicon substrate, wherein the silicon substrate has been doped to the second conductivity type in the second reset transistor well. The emitter electrode may be electrically connected to the gate electrode of a field-effect transistor pixel and the collector electrode may be electrically connected to a reset voltage source.

The bipolar reset transistor can be prepared in the same silicon substrate and in the same manufacturing process as the field-effect transistor pixel, without additional masking steps. It can also be easily prepared in standard CMOS processes.

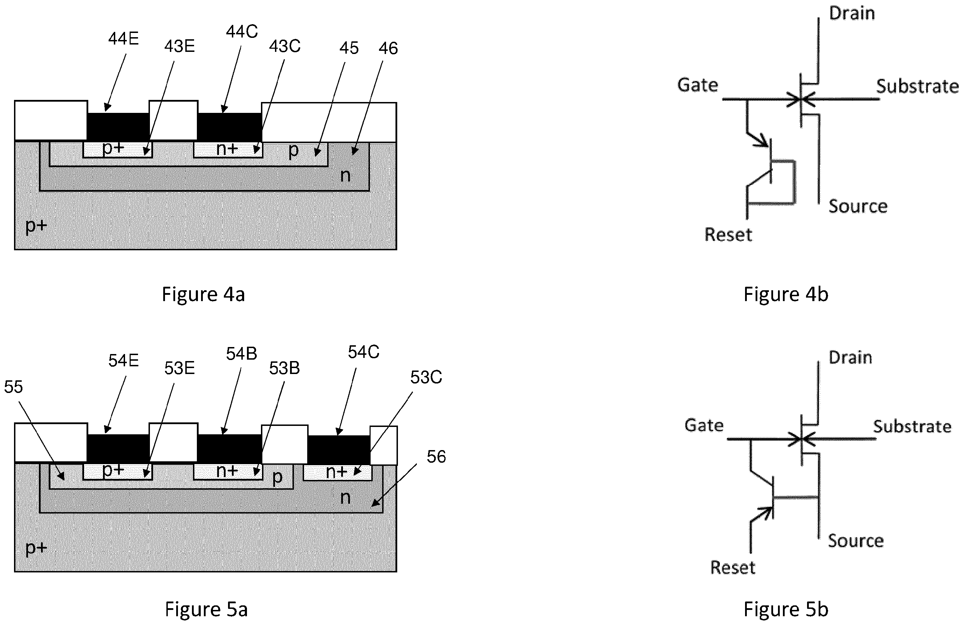

Figure 4a illustrates a bipolar pnp reset-transistor for removing positive accumulated charge from the channel region of a field-effect transistor pixel. In this case, the first conductivity type is p-type and the second is n-type. This bipolar reset-transistor is suitable for resetting the field-effect transistor pixel illustrated in Figure 1, where the source region 13S has been doped to p-type, the gate region 13G to n-type and the drain region 13D to p-type. If the conductivities in the source, gate and drain region of the field-effect transistor pixel would be reversed (n, p, n, respectively), then the bipolar reset transistor would be an npn transistor.
Figure 4b illustrates the corresponding reset circuit for one field-effect transistor pixel. The bipolar pnp transistor illustrated in Figures 4a and 4b has been connected as a diode.
The transistor illustrated in Figure 4a comprises a p+ doped emitter region 43E and an n+ doped collector region 43C. The corresponding emitter electrode 44E and collector electrode 44C have been deposited on top of the emitter and collector regions,
respectively. Both the emitter region and the collector region are encompassed within a p-doped first reset transistor well 45 and a deeper, n-doped second reset transistor well 46.
The n-doped well 46 may the same well which forms an n-doped transistor well 36 in an adjacent field-effect transistor pixel, or it may be a separate well.

When a positive bias voltage is applied to the collector electrode, the emitter-base junction of the bipolar transistor is reverse-biased and the bipolar transistor is in cutoff-mode where no current flows between the collector and the emitter. When a negative bias voltage is applied to the collector electrode, the bipolar transistor is in active mode, and current flows from the emitter to the collector, in other words from the channel region in the field-effect transistor pixel to the collector electrode in the bipolar transistor. The field-effect transistor is thereby quickly emptied of accumulated charge carriers and ready for a new measurement. This pnp reset-transistor covers a small surface area, so a separate reset pnp-transistor can be prepared adjacent to each field-effect transistor pixel.

If the charge which has accumulated in the channel region of a photosensitive field-effect transistor is negative, then the electrical means for resetting a field-effect transistor pixel may, for example, include a bipolar reset transistor which may comprise an emitter region doped to the first conductivity type in the silicon substrate, with a conductive emitter electrode connected to the emitter region, a base region doped to the second conductivity type in the silicon substrate, with a conductive base electrode connected to the collector region, and a collector region doped to the second conductivity type in the silicon substrate, with a conductive base electrode connected to the collector region. The bipolar reset transistor may further include a first reset transistor well encompassing the emitter and collector regions on the front surface of the silicon substrate, wherein the silicon substrate has been doped to the first conductivity type in the first reset transistor well, and a second reset transistor well encompassing the emitter and collector regions on the front surface of the silicon substrate, wherein the silicon substrate has been doped to the second conductivity type in the second reset transistor well,

The collector electrode may be electrically connected to the gate electrode of the field-effect transistor pixel. The base electrode may electrically be connected to the source electrode of the same field-effect transistor pixel, and the emitter electrode may be electrically connected to a reset voltage source.

As before, the bipolar reset transistor can be prepared in the same silicon substrate and in the same manufacturing process as the field-effect transistor pixel, without additional masking steps. Figure 5a illustrates a bipolar pnp reset-transistor which can be used for removing positive accumulated charge from the channel region of a field-effect transistor pixel. In this case, the first conductivity type is p-type and the second is n-type. As above, this bipolar reset-transistor is suitable for resetting the field-effect transistor pixel illustrated in Figure 1, where the source region 13S has been doped to p-type, the gate region 13G to n-type and the drain region 13D to p-type. Figure 5b illustrates the corresponding reset circuit for one field-effect transistor pixel. If the conductivities in the source, gate and drain region would be reversed (n, p, n, respectively), then the bipolar reset transistor should be implemented as an npn transistor.

The transistor illustrated in Figure 5a comprises p-doped emitter region 53E, n-doped base region 53B, and n-doped collector region 53C, with corresponding contact electrodes 54E, 54B and 54C. The first reset transistor well is 55 and the deeper second reset transistor well is 56.

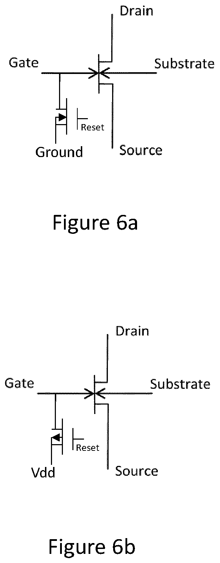

The silicon substrate may also comprise one or more nMOS reset transistors which are dedicated to resetting a field-effect transistor pixel by emptying the channel of positive charge. Each nMOS transistor may comprise an nMOS drain region with a conductive nMOS drain electrode connected to the nMOS drain region, wherein the drain electrode is electrically connected to the gate electrode of the field-effect transistor pixel, and an nMOS gate region with a conductive nMOS gate electrode connected to the nMOS gate region, wherein the nMOS gate electrode is electrically connected to a reset voltage source. The nMOS transistor may further comprise an nMOS source region with a conductive nMOS source electrode connected to the nMOS source region, wherein the nMOS source electrode is electrically connected to the ground potential. Figure 6a illustrates the corresponding reset circuit for one field-effect transistor pixel.

The width-to-length ratio of the nMOS reset transistor channel should be dimensioned by layout to feed the modulated charge from pixel transistor channel to either ground or power supply Vdd.

The silicon substrate may also comprise one or more pMOS reset transistors which are dedicated for resetting a field-effect transistor pixel by emptying the channel of negative charge. Each pMOS transistor may comprise a pMOS drain region with a conductive pMOS drain electrode connected to the pMOS drain region, wherein the drain electrode is electrically connected to the gate electrode of the field-effect transistor pixel, and a pMOS gate region with a conductive pMOS gate electrode connected to the pMOS gate region, wherein the pMOS drain electrode is electrically connected to a reset voltage source. Each pMOS transistor may further comprise a pMOS source region with a conductive pMOS source electrode connected to the pMOS source region, wherein the pMOS source electrode is electrically connected to the highest voltage available. Figure 6b illustrates the corresponding reset circuit for one field-effect transistor pixel.

Again, the width-to-length ratio of the pMOS reset transistor channel should be dimensioned by layout to feed the modulated charge from pixel transistor channel to either ground or power supply Vdd.

Methods for resetting the photovoltaic field-effect transistor pixels described in this disclosure comprise the steps of preparing one of the reset transistors described above, and then applying a reset voltage to the electrode connected to a reset voltage source, thereby resetting the field-effect transistor pixel by transferring charge carriers away from its channel region.

In other words, in a method for resetting a field-effect transistor pixel, a bipolar transistor may be prepared by doping and deposition on the front surface of the silicon substrate, wherein the bipolar transistor comprises an emitter region doped to the first conductivity type in the silicon substrate, with a conductive emitter electrode connected to the emitter region, and a collector region doped to the second conductivity type in the silicon substrate, with a conductive collector electrode connected to the collector region. A first reset transistor well encompassing the emitter and collector regions may be prepared on the front surface of the silicon substrate, wherein the silicon substrate has been doped to the first conductivity type in the first reset transistor well, and a second reset transistor well encompassing the emitter and collector regions may also be prepared on the front surface of the silicon substrate, wherein the silicon substrate has been doped to the second conductivity type in the second reset transistor well. A reset voltage may then be applied to the collector electrode to transfer charge carriers away from the channel region in the field-effect transistor pixel.

Alternatively, in a method for resetting a field-effect transistor pixel, a bipolar transistor may be prepared by doping and deposition on the front surface of the silicon substrate, wherein the bipolar transistor comprises an emitter region doped to the first conductivity type in the silicon substrate, with a conductive emitter electrode connected to the emitter region, a base region doped to the second conductivity type in the silicon substrate, with a conductive base electrode connected to the collector region, and a collector region doped to the second conductivity type in the silicon substrate, with a conductive base electrode connected to the collector region. A first reset transistor well encompassing the emitter and collector regions may be prepared on the front surface of the silicon substrate, wherein the silicon substrate has been doped to the first conductivity type in the first reset transistor well, and a second reset transistor well encompassing the emitter and collector regions may be prepared on the front surface of the silicon substrate, wherein the silicon substrate has been doped to the second conductivity type in the second reset transistor well. The collector electrode may be electrically connected to the gate electrode of the field-effect transistor pixel, the base electrode may be electrically connected to the source electrode of the same field-effect transistor pixel, and a reset voltage may be applied to the emitter electrode to transfer charge carriers away from the channel region in the field-effect transistor pixel.

Alternatively, in a method for resetting the channel region in a field-effect transistor pixel, an nMOS transistor may be prepared by doping and deposition on the front surface of the silicon substrate, comprising an nMOS drain region with a conductive nMOS drain electrode connected to the nMOS drain region, an nMOS gate region with a conductive nMOS gate electrode connected to the nMOS gate region, and an nMOS source region with a conductive nMOS source electrode connected to the nMOS source region. The nMOS drain electrode may be electrically connected to the gate electrode of the field-effect transistor pixel, the nMOS gate electrode may be electrically connected to a reset voltage source, and the nMOS source electrode may be electrically connected to the ground potential. A reset voltage may be applied to the nMOS gate electrode to transfer charge carriers away from the channel region in the field-effect transistor pixel.

Alternatively, in a method for resetting the channel region in a field-effect transistor pixel, a pMOS transistor may be prepared by doping and deposition on the front surface of the silicon substrate, comprising a pMOS drain region with a conductive pMOS drain electrode connected to the pMOS drain region, a pMOS gate region with a conductive pMOS gate electrode connected to the pMOS gate region, and a pMOS source region with a conductive pMOS source electrode connected to the pMOS source region. The pMOS drain electrode may be electrically connected to the gate electrode of the field-effect transistor pixel, the pMOS gate electrode may be electrically connected to a reset voltage source, and the pMOS source electrode may be electrically connected to the highest voltage available. A reset voltage may be applied to the pMOS gate electrode to transfer charge carriers away from the channel region in the field-effect transistor pixel.

## Claims

1. A photodetector with a front surface (111, 211) and a back surface (112, 212), wherein the photodetector comprises a silicon substrate (12, 22) with a corresponding front surface (121, 221) and a corresponding back surface (122, 222), and the silicon substrate (12, 22) comprises one or more field-effect transistor pixels which comprise:
- a source region (13S, 23S) on the front surface (121, 221) of the silicon substrate (12, 22) and a conductive source electrode (14S, 24S) connected to the source region (13S, 23S),
- a gate region (13G, 23G) on the front surface (121, 221) of the silicon substrate (12, 22) and a conductive gate electrode (14G, 24G) connected to the gate region (13G, 23G),
- a drain region (13D, 23D) on the front surface (121, 221) of the silicon substrate (12, 22) and a conductive drain electrode (14D, 24D) connected to the drain region (13D, 23D),
- a transistor channel region (15, 25) encompassing the source, gate and drain regions on the front surface of the silicon substrate, wherein the silicon substrate (12, 22) has been doped to a first conductivity type in the transistor channel region (15, 25),
- a transistor well (16, 26) encompassing the transistor channel region on the front surface (121, 221) of the silicon substrate, wherein the silicon substrate (12, 22) has been doped to a second conductivity type in the transistor well (16, 26),
**characterized in that**
- the one or more field-effect transistor pixels further comprise a cavity (171, 271) extending from the back surface of the silicon substrate to the transistor channel region (15, 25), wherein the top of the cavity comprises a photoactive layer (18, 28) which is in contact with the transistor channel region (15, 25) and configured to generate a photovoltage at the interface between the photoactive layer (18, 28) and the transistor channel region (15, 25), and wherein the cavity (171, 271) also comprises an at least partly transparent encapsulation layer (19, 29) overlying the photoactive layer (18, 28) in the cavity, and that
- one or more openings (172, 272) in the back surface (112, 212) of the photodetector are aligned with one or more field-effect transistor pixels and allow electromagnetic radiation to reach the cavity (171, 271) in the one or more field-effect transistor pixels.

2. A photodetector according to claim 1, wherein the source region (13S) is a region doped to a first conductivity type in the silicon substrate, the gate region (13G) is a region doped to a second conductivity type in the silicon substrate, and the drain region (13D) is a region doped to the first conductivity type in the silicon substrate.

3. A photodetector according to claim 1, wherein the source, gate and drain regions (23S, 23G, 23D) comprise an insulating layer deposited on top of the front surface of the silicon substrate and a layer of polycrystalline silicon deposited on the insulating layer.

4. A photodetector according to any preceding claim, wherein the horizontal width of the photoactive layer (18, 28) is greater than the horizontal width of the cavity (171, 271).

5. A photodetector according to claim 4, wherein the silicon substrate also comprises one or more bipolar transistors configured to reset a field-effect transistor pixel, wherein each bipolar transistor comprises:
- an emitter region (43E) doped to the first conductivity type in the silicon substrate, with a conductive emitter electrode (44E) connected to the emitter region (43E),
- a collector region (43C) doped to the second conductivity type in the silicon substrate, with a conductive collector electrode (44C) connected to the collector region (43C),
- a first reset transistor well (45) encompassing the emitter and collector regions on the front surface of the silicon substrate, wherein the silicon substrate has been doped to the first conductivity type in the first reset transistor well (45),
- a second reset transistor well (46) encompassing the emitter and collector regions on the front surface of the silicon substrate, wherein the silicon substrate has been doped to the second conductivity type in the second reset transistor well (46),
and wherein the emitter electrode (44E) is electrically connected to the gate electrode of a field-effect transistor pixel and the collector electrode (44C) is electrically connected to a reset voltage source.

6. A photodetector according to claim 4, wherein the silicon substrate also comprises one or more bipolar transistors configured to reset a field-effect transistor pixel, wherein each bipolar transistor comprises:
- an emitter region (53E) doped to the first conductivity type in the silicon substrate, with a conductive emitter electrode connected to the emitter region,
- a base region (53B) doped to the second conductivity type in the silicon substrate, with a conductive base electrode connected to the collector region,
- a collector region (53C) doped to the second conductivity type in the silicon substrate, with a conductive base electrode connected to the collector region,
- a first reset transistor well (55) encompassing the emitter and collector regions on the front surface of the silicon substrate, wherein the silicon substrate has been doped to the first conductivity type in the first reset transistor well (55),
- a second reset transistor well (56) encompassing the emitter and collector regions on the front surface of the silicon substrate, wherein the silicon substrate has been doped to the second conductivity type in the second reset transistor well (56),
wherein the collector electrode is electrically connected to the gate electrode of the field-effect transistor pixel, the base electrode is electrically connected to the source electrode of the same field-effect transistor pixel, and the emitter electrode is electrically connected to a reset voltage source.

7. A photodetector according to claim 4, wherein the silicon substrate also comprises one or more nMOS transistors configured to reset a field-effect transistor pixel, wherein each nMOS transistor comprises
- an nMOS drain region with a conductive nMOS drain electrode connected to the nMOS drain region, wherein the drain electrode is electrically connected to the gate electrode of the field-effect transistor pixel,
- an nMOS gate region with a conductive nMOS gate electrode connected to the nMOS gate region, wherein the nMOS gate electrode is electrically connected to a reset voltage source,
- an nMOS source region with a conductive nMOS source electrode connected to the nMOS source region, wherein the nMOS source electrode is electrically connected to the ground potential.

8. A photodetector according to claim 4, wherein the silicon substrate also comprises one or more pMOS transistors configured to reset a field-effect transistor pixel, wherein each pMOS transistor comprises
- an pMOS drain region with a conductive pMOS drain electrode connected to the pMOS drain region, wherein the drain electrode is electrically connected to the gate electrode of the field-effect transistor pixel,
- an pMOS gate region with a conductive pMOS gate electrode connected to the pMOS gate region, wherein the pMOS drain electrode is electrically connected to a reset voltage source,
- an pMOS source region with a conductive pMOS source electrode connected to the pMOS source region, wherein the pMOS source electrode is electrically connected to the highest voltage available.

9. A method for manufacturing a photosensitive field-effect transistor in a silicon substrate of a first conductivity type, wherein the method comprises the steps of:
- doping a transistor well (36) with a second conductivity type on a first area (A₁) on the front surface (321) of the silicon substrate, to a first depth from the front surface of the silicon substrate,
- doping a transistor channel region (35) on a second area (A₂) which lies within the first area on the front surface (321) of the silicon substrate, to a second depth from the front surface of the silicon substrate, whereby the second depth is less than the first depth so that the transistor channel region (35) is encompassed by the transistor well (36),
- preparing source (33S), gate (33G) and drain (33D) regions within the second area on the front surface of the silicon substrate, so that the source, gate and drain regions are encompassed by the transistor channel region,
- forming a cavity (37) extending from the back surface (322) of the silicon substrate to the second depth from the front surface of the silicon substrate,
- forming a dielectric layer (31) on the back surface of the silicon substrate, with an opening at the top of the cavity,
- forming a photoactive layer (38) on an area of the back surface of the silicon substrate which covers at least the top of the cavity, whereby the photoactive layer makes contact with the transistor channel and is configured to generate a photovoltage at the interface between the photoactive layer and the channel region when illuminated by electromagnetic radiation.

## Patentansprüche

1. Fotodetektor mit einer Vorderseite (111, 211) und einer Rückseite (112, 212), wobei der Fotodetektor ein Siliziumsubstrat (12, 22) mit einer entsprechenden Vorderseite (121, 221) und einer entsprechenden Rückseite (122, 222) umfasst und das Siliziumsubstrat (12, 22) ein oder mehrere Feldeffekttransistor-Pixel umfasst, welche aufweisen:
- einen Source-Bereich (13S, 23S) auf der Vorderseite (121, 221) des Siliziumsubstrats (12, 22) und eine mit dem Source-Bereich (13S, 23S) verbundene leitfähige Source-Elektrode (14S, 24S),
- einen Gate-Bereich (13G, 23G) auf der Vorderseite (121, 221) des Siliziumsubstrats (12, 22) und eine mit dem Gate-Bereich (13G, 23G) verbundene leitfähige Gate-Elektrode (14G, 24G),
- einen Drain-Bereich (13D, 23D) auf der Vorderseite (121, 221) des Siliziumsubstrats (12, 22) und eine mit dem Drain-Bereich (13D, 23D) verbundene leitfähige Drain-Elektrode (14D, 24D),
- einen die Source-, Gate- und Drain-Bereiche einschließenden Transistorkanalbereich (15, 25) auf der Vorderseite des Siliziumsubstrats, wobei das Siliziumsubstrat (12, 22) auf einen ersten Leitfähigkeitstyp im Transistorkanalbereich (15, 25) dotiert ist,
- eine den Transistorkanalbereich einschließende Transistorwanne (16, 26) auf der Vorderseite (121, 221) des Siliziumsubstrats, wobei das Siliziumsubstrat (12, 22) auf einen zweiten Leitfähigkeitstyp in der Transistorwanne (16, 26) dotiert ist,
**dadurch gekennzeichnet, dass**
- das eine oder die mehreren Feldeffekttransistor-Pixel ferner eine Vertiefung (171, 271) aufweisen, die sich von der Rückseite des Siliziumsubstrats zum Transistorkanalbereich (15, 25) erstreckt, wobei die Oberseite der Vertiefung eine fotoaktive Schicht (18, 28) aufweist, die in Kontakt mit dem Transistorkanalbereich (15, 25) ist und dazu ausgelegt ist, eine Fotospannung an der Grenzfläche zwischen der fotoaktiven Schicht (18, 28) und dem Transistorkanalbereich (15, 25) zu erzeugen, und wobei die Vertiefung (171, 271) auch eine zumindest teilweise transparente Kapselungsschicht (19, 29) aufweist, die die fotoaktive Schicht (18, 28) in der Vertiefung überlagert, und dass
- eine oder mehrere Öffnungen (172, 272) in der Rückseite (112, 212) des Fotodetektors mit einem oder mehreren Feldeffekttransistor-Pixeln gefluchtet sind und es ermöglichen, dass elektromagnetische Strahlung die Vertiefung (171, 271) in dem einen oder den mehreren Feldeffekttransistor-Pixeln erreicht.

2. Fotodetektor nach Anspruch 1, wobei der Source-Bereich (13S) ein auf einen ersten Leitfähigkeitstyp dotierter Bereich im Siliziumsubstrat ist, der Gate-Bereich (13G) ein auf einen zweiten Leitfähigkeitstyp dotierter Bereich im Siliziumsubstrat ist, und der Drain-Bereich (13D) ein auf den ersten Leitfähigkeitstyp dotierter Bereich im Siliziumsubstrat ist.

3. Fotodetektor nach Anspruch 1, wobei die Source-, Gate- und Drain-Bereiche (23S, 23G, 23D) eine oben auf der Vorderseite des Siliziumsubstrats abgeschiedene Isolierschicht und eine auf der Isolierschicht abgeschiedene Schicht von polykristallinem Silizium aufweisen.

4. Fotodetektor nach einem vorhergehenden Anspruch, wobei die horizontale Breite der fotoaktiven Schicht (18, 28) größer als die horizontale Breite der Vertiefung (171, 271) ist.

5. Fotodetektor nach Anspruch 4, wobei das Siliziumsubstrat auch einen oder mehrere bipolare Transistoren umfasst, die dazu ausgelegt sind, ein Feldeffekttransistor-Pixel zurückzusetzen, wobei jeder bipolare Transistor umfasst:
- einen auf den ersten Leitfähigkeitstyp dotierten Emitter-Bereich (43E) im Siliziumsubstrat, mit einer mit dem Emitter-Bereich (43E) verbundenen leitfähigen Emitter-Elektrode (44E),
- einen auf den zweiten Leitfähigkeitstyp dotierten Kollektor-Bereich (43C) im Siliziumsubstrat, mit einer mit dem Kollektor-Bereich (43C) verbundenen leitfähigen Kollektor-Elektrode (44C),
- eine den Emitter- und Kollektor-Bereich einschließende erste Reset-Transistorwanne (45) auf der Vorderseite des Siliziumsubstrats, wobei das Siliziumsubstrat in der ersten Reset-Transistorwanne (45) auf den ersten Leitfähigkeitstyp dotiert ist,
- eine den Emitter- und Kollektor-Bereich einschließende zweite Reset-Transistorwanne (46) auf der Vorderseite des Siliziumsubstrats, wobei das Siliziumsubstrat in der zweiten Reset-Transistorwanne (46) auf den zweiten Leitfähigkeitstyp dotiert ist,
und wobei die Emitter-Elektrode (44E) mit der Gate-Elektrode eines Feldeffekttransistor-Pixels elektrisch verbunden ist und die Kollektor-Elektrode (44C) mit einer Reset-Spannungsquelle elektrisch verbunden ist.

6. Fotodetektor nach Anspruch 4, wobei das Siliziumsubstrat auch einen oder mehrere bipolare Transistoren umfasst, die dazu ausgelegt sind, ein Feldeffekttransistor-Pixel zurückzusetzen, wobei jeder bipolare Transistor umfasst:
- einen auf den ersten Leitfähigkeitstyp dotierten Emitter-Bereich (53E) im Siliziumsubstrat, mit einer mit dem Emitter-Bereich verbundenen leitfähigen Emitter-Elektrode,
- einen auf den zweiten Leitfähigkeitstyp dotierten Basisbereich (53B) im Siliziumsubstrat, mit einer mit dem Kollektor-Bereich verbundenen leitfähigen Basiselektrode,
- einen auf den zweiten Leitfähigkeitstyp dotierten Kollektor-Bereich (53C) im Siliziumsubstrat, mit einer mit dem Kollektor-Bereich verbundenen leitfähigen Basiselektrode,
- eine den Emitter- und Kollektor-Bereich einschließende erste Reset-Transistorwanne (55) auf der Vorderseite des Siliziumsubstrats, wobei das Siliziumsubstrat in der ersten Reset-Transistorwanne (55) auf den ersten Leitfähigkeitstyp dotiert ist,
- eine den Emitter- und Kollektor-Bereich einschließende zweite Reset-Transistorwanne (56) auf der Vorderseite des Siliziumsubstrats, wobei das Siliziumsubstrat in der zweiten Reset-Transistorwanne (56) auf den zweiten Leitfähigkeitstyp dotiert ist,
wobei die Kollektor-Elektrode mit der Gate-Elektrode des Feldeffekttransistor-Pixels elektrisch verbunden ist, die Basiselektrode mit der Source-Elektrode des gleichen Feldeffekttransistor-Pixels elektrisch verbunden ist, und die Emitter-Elektrode mit einer Reset-Spannungsquelle elektrisch verbunden ist.

7. Fotodetektor nach Anspruch 4, wobei das Siliziumsubstrat auch einen oder mehrere nMOS-Transistoren umfasst, die dazu ausgelegt sind, ein Feldeffekttransistor-Pixel zurückzusetzen, wobei jeder nMOS-Transistor umfasst
- einen nMOS-Drain-Bereich mit einer mit dem nMOS-Drain-Bereich verbundenen leitfähigen nMOS-Drain-Elektrode, wobei die Drain-Elektrode mit der Gate-Elektrode des Feldeffekttransistor-Pixels elektrisch verbunden ist,
- einen nMOS-Gate-Bereich mit einer mit dem nMOS-Gate-Bereich verbundenen leitfähigen nMOS-Gate-Elektrode, wobei die nMOS-Gate-Elektrode mit einer Reset-Spannungsquelle elektrisch verbunden ist,
- einen nMOS-Source-Bereich mit einer mit dem nMOS-Source-Bereich verbundenen leitfähigen nMOS-Source-Elektrode, wobei die nMOS-Source-Elektrode mit dem Erdpotenzial elektrisch verbunden ist.

8. Fotodetektor nach Anspruch 4, wobei das Siliziumsubstrat auch einen oder mehrere pMOS-Transistoren umfasst, die dazu ausgelegt sind, ein Feldeffekttransistor-Pixel zurückzusetzen, wobei jeder pMOS-Transistor umfasst
- einen pMOS-Drain-Bereich mit einer mit dem pMOS-Drain-Bereich verbundenen leitfähigen pMOS-Drain-Elektrode, wobei die Drain-Elektrode mit der Gate-Elektrode des Feldeffekttransistor-Pixels elektrisch verbunden ist,
- einen pMOS-Gate-Bereich mit einer mit dem pMOS-Gate-Bereich verbundenen leitfähigen pMOS-Gate-Elektrode, wobei die pMOS-Drain-Elektrode mit einer Reset-Spannungsquelle elektrisch verbunden ist,
- einen pMOS-Source-Bereich mit einer mit dem pMOS-Source-Bereich verbundenen leitfähigen pMOS-Source-Elektrode, wobei die pMOS-Source-Elektrode mit der höchsten verfügbaren Spannung elektrisch verbunden ist.

9. Verfahren zur Herstellung eines lichtempfindlichen Feldeffekttransistors in einem Siliziumsubstrat eines ersten Leitfähigkeitstyps, wobei das Verfahren die Schritte umfasst:
- Dotieren einer Transistorwanne (36) mit einem zweiten Leitfähigkeitstyp auf einer ersten Fläche (A₁) auf der Vorderseite (321) des Siliziumsubstrats auf eine erste Tiefe ab der Vorderseite des Siliziumsubstrats,
- Dotieren eines Transistorkanalbereichs (35) auf einer zweiten Fläche (A₂), die innerhalb der ersten Fläche auf der Vorderseite (321) des Siliziumsubstrats liegt, auf eine zweite Tiefe ab der Vorderseite des Siliziumsubstrats, wobei die zweite Tiefe kleiner als die erste Tiefe ist, so dass der Transistorkanalbereich (35) in der Transistorwanne (36) eingeschlossen ist,
- Vorbereiten des Source-Bereichs (33S), Gate-Bereichs (33G) und Drain-Bereichs (33D) in der zweiten Fläche auf der Vorderseite des Siliziumsubstrats, so dass die Source-, Gate- und Drain-Bereiche im Transistorkanalbereich eingeschlossen sind,
- Ausbilden einer Vertiefung (37), die sich von der Rückseite (322) des Siliziumsubstrats bis zur zweiten Tiefe ab der Vorderseite des Siliziumsubstrats erstreckt,
- Ausbilden einer dielektrischen Schicht (31) auf der Rückseite des Siliziumsubstrats mit einer Öffnung an der Oberseite der Vertiefung,
- Ausbilden einer fotoaktiven Schicht (38) auf einer Fläche der Rückseite des Siliziumsubstrats, die mindestens die Oberseite der Vertiefung bedeckt, wobei die fotoaktive Schicht in Kontakt mit dem Transistorkanal kommt und dazu ausgelegt ist, bei Einfall einer elektromagnetischen Strahlung eine Fotospannung an der Grenzfläche zwischen der fotoaktiven Schicht und dem Kanalbereich zu erzeugen.

## Revendications

1. Photodétecteur avec une face avant (111, 211) et une face arrière (112, 212), dans lequel le photodétecteur comprend un substrat de silicium (12, 22) avec une face avant correspondante (121, 221) et une face arrière correspondante (122, 222), et le substrat de silicium (12, 22) comprend un ou plusieurs pixels à transistor à effet de champ qui comprennent :
- une région source (13S, 23S) sur la face avant (121, 221) du substrat de silicium (12, 22) et une électrode source conductrice (14S, 24S) reliée à la région source (13S, 23S),
- une région grille (13G, 23G) sur la face avant (121, 221) du substrat de silicium (12, 22) et une électrode grille conductrice (14G, 24G) reliée à la région grille (13G, 23G),
- une région drain (13D, 23D) sur la face avant (121, 221) du substrat de silicium (12, 22) et une électrode drain conductrice (14D, 24D) reliée à la région drain (13D, 23D),
- une région canal de transistor (15, 25) englobant les régions source, grille et drain sur la face avant du substrat de silicium, ledit substrat de silicium (12, 12) ayant été dopé pour un premier type de conductivité dans la région canal de transistor (15, 25),
- un puits de transistor (16, 26) englobant la région canal de transistor sur la face avant (121, 122) du substrat de silicium, ledit substrat de silicium (12, 12) ayant été dopé pour un deuxième type de conductivité dans le puits de transistor (16, 26),
**caractérisé en ce que**
- lesdits un ou plusieurs pixels à transistor à effet de champ comprennent également une cavité (171, 271) qui s'étend de la face arrière du substrat de silicium jusqu'à la région canal de transistor (15, 25), le côté supérieur de ladite cavité comprenant une couche photoactive (18, 28) qui est en contact avec la région canal de transistor (15, 25) et configuré pour générer une phototension à l'interface entre la couche photoactive (18, 28) et la région canal de transistor (15, 25), et ladite cavité (171, 271) comprenant également une couche d'encapsulation au moins partiellement transparente (19, 29) recouvrant la couche photoactive (18, 28) dans la cavité, et que
- un ou plusieurs orifices (172, 272) dans la face arrière (112, 212) du photodétecteur sont alignés sur un ou plusieurs pixels à transistor à effet de champ et permettent à un rayonnement électromagnétique d'atteindre la cavité (171, 271) dans lesdits un ou plusieurs pixels à transistor à effet de champ.

2. Photodétecteur selon la revendication 1, dans lequel la région source (13S) est une région dopée pour un premier type de conductivité dans le substrat de silicium, la région grille (13G) est une région dopée pour un deuxième type de conductivité dans le substrat de silicium, et la région drain (13D) est une région dopée pour le premier type de conductivité dans le substrat de silicium.

3. Photodétecteur selon la revendication 1, dans lequel les régions source, grille et drain (23S, 23G, 23D) comprennent une couche isolante déposée sur le dessus de la face avant du substrat de silicium et une couche de silicium polycristallin déposée sur la couche isolante.

4. Photodétecteur selon une revendication précédente quelconque, dans lequel la largeur horizontale de la couche photoactive (18, 28) est supérieure à la largeur horizontale de la cavité (171, 271).

5. Photodétecteur selon la revendication 4, dans lequel le substrat de silicium comprend également un ou plusieurs transistors bipolaires configurés pour réinitialiser un pixel à transistor à effet de champ, chaque transistor bipolaire comprenant :
- une région d'émetteur (43E) dopée pour le premier type de conductivité dans le substrat de silicium, avec une électrode-émetteur conductrice (44E) reliée à la région d'émetteur (43E),
- une région de collecteur (43C) dopée pour le deuxième type de conductivité dans le substrat de silicium, avec une électrode-collecteur conductrice (44C) reliée à la région de collecteur (43C),
- un premier puits de transistor de réinitialisation (45) englobant les régions d'émetteur et de collecteur sur la face avant du substrat de silicium, ledit substrat de silicium ayant été dopé pour le premier type de conductivité dans le premier puits de transistor de réinitialisation (45),
- un deuxième puits de transistor de réinitialisation (46) englobant les régions d'émetteur et de collecteur sur la face avant du substrat de silicium, ledit substrat de silicium ayant été dopé pour le deuxième type de conductivité dans le deuxième puits de transistor de réinitialisation (46),
et dans lequel l'électrode-émetteur (44E) est connectée électriquement à l'électrode-grille d'un pixel à transistor à effet de champ et l'électrode-collecteur (44C) est connectée électriquement à une source de tension de réinitialisation.

6. Photodétecteur selon la revendication 4, dans lequel le substrat de silicium comprend également un ou plusieurs transistors bipolaires configurés pour réinitialiser un pixel à transistor à effet de champ, chaque transistor bipolaire comprenant :
- une région d'émetteur (53E) dopée pour le premier type de conductivité dans le substrat de silicium, avec une électrode-émetteur conductrice reliée à la région d'émetteur,
- une région de base (53B) dopée pour le deuxième type de conductivité dans le substrat de silicium, avec une électrode de base conductrice reliée à la région de collecteur,
- une région de collecteur (53C) dopée pour le deuxième type de conductivité dans le substrat de silicium, avec une électrode de base conductrice reliée à la région de collecteur,
- un premier puits de transistor de réinitialisation (55) englobant les régions d'émetteur et de collecteur sur la face avant du substrat de silicium, ledit substrat de silicium ayant été dopé pour le premier type de conductivité dans le premier puits de transistor de réinitialisation (55),
- un deuxième puits de transistor de réinitialisation (56) englobant les régions d'émetteur et de collecteur sur la face avant du substrat de silicium, ledit substrat de silicium ayant été dopé pour le deuxième type de conductivité dans le deuxième puits de transistor de réinitialisation (56),
ladite électrode-collecteur étant connectée électriquement à l'électrode-grille du pixel à transistor à effet de champ, ladite électrode de base étant connectée électriquement à l'électrode-source du même pixel à transistor à effet de champ, et ladite électrode-émetteur étant connectée électriquement à une source de tension de réinitialisation.

7. Photodétecteur selon la revendication 4, dans lequel le substrat de silicium comprend également un ou plusieurs transistors nMOS configurés pour réinitialiser un pixel à transistor à effet de champ, chaque transistor nMOS comprenant
- une région drain nMOS avec une électrode-drain nMOS conductrice reliée à la région drain nMOS, ladite électrode-drain étant connectée électriquement à l'électrode-grille du pixel à transistor à effet de champ,
- une région grille nMOS avec une électrode-grille nMOS conductrice reliée à la région grille nMOS, ladite électrode-grille nMOS étant connectée électriquement à une source de tension de réinitialisation,
- une région source nMOS avec une électrode-source nMOS conductrice reliée à la région source nMOS, ladite électrode-source nMOS étant connectée électriquement au potentiel de terre.

8. Photodétecteur selon la revendication 4, dans lequel le substrat de silicium comprend également un ou plusieurs transistors pMOS configurés pour réinitialiser un pixel à transistor à effet de champ, chaque transistor pMOS comprenant
- une région drain pMOS avec une électrode-drain pMOS conductrice reliée à la région drain pMOS, ladite électrode-drain étant connectée électriquement à l'électrode-grille du pixel à transistor à effet de champ,
- une région grille pMOS avec une électrode-grille pMOS conductrice reliée à la région grille pMOS, ladite électrode-drain pMOS étant connectée électriquement à une source de tension de réinitialisation,
- une région source pMOS avec une électrode-source pMOS conductrice reliée à la région source pMOS, ladite électrode-source pMOS étant connectée électriquement à la tension la plus élevée disponible.

9. Procédé de fabrication d'un transistor à effet de champ photosensible dans un substrat de silicium d'un premier type de conductivité, ledit procédé comprenant les étapes consistant à
- doper un puits de transistor (36) d'un deuxième type de conductivité dans une première zone (A₁) sur la face avant (321) du substrat de silicium, pour une première profondeur à partir de la face avant du substrat de silicium,
- doper une région canal de transistor (35) dans une deuxième zone (A₂) qui est située à l'intérieur de la première zone sur la face avant (321) du substrat de silicium, pour une deuxième profondeur à partir de la face avant du substrat de silicium, la deuxième profondeur étant inférieure à la première profondeur de telle façon que la région canal de transistor (35) soit englobée dans le puits de transistor (36),
- préparer les régions source (33S), grille (33G) et drain (33D) à l'intérieur de la deuxième zone sur la face avant du substrat de silicium de telle façon que les régions source, grille et drain soient englobées dans la région canal de transistor,
- former une cavité (37) s'étendant de la face arrière (322) du substrat de silicium jusqu'à la deuxième profondeur à partir de la face avant du substrat de silicium,
- former une couche diélectrique (31) sur la face arrière du substrat de silicium, avec un orifice en haut de la cavité,
- former une couche photoactive (38) dans une zone de la face arrière du substrat de silicium qui recouvre au moins le haut de la cavité, ladite couche photoactive entrant en contact avec le canal de transistor et étant configurée pour générer une phototension à l'interface entre la couche photoactive et la région canal lorsqu'elle est exposée à un rayonnement électromagnétique.
